# EUROPÄISCHE PATENTSCHRIFT

(11) **EP 1 063 700 B1**
(45) Veröffentlichungstag und Bekanntmachung des Hinweises auf die Patenterteilung: **25.07.2012**
(21) Anmeldenummer: 00111519.5
(22) Anmeldetag: 29.05.2000
(51) Int. Cl.: H01L 23/498, H05K 1/02, H01L 23/60, H01L 23/15, H05K 1/03, H05K 1/16, H05K 3/40

(54) **Substrat für Hochspannungsmodule**
Substrate for high voltage modules
Substrat pour des modules haute tension

(30) Priorität: 22.06.1999 DE 19928578
(43) Veröffentlichungstag der Anmeldung: 27.12.2000
(60) Teilanmeldung: 07109221.7
(73) Patentinhaber: Infineon Technologies AG, 85579 Neubiberg (DE)
(72) Erfinder: Stoisiek, Michael, Dr., 85521 Ottobrunn (DE); Lefranc, Guy, 80634 München (DE); Bayerer, Reinhold, Dr., 59581 Warstein (DE); Leuschner, Rainer, Dr., 91091 Grossenseebach (DE)
(74) Vertreter: Kottmann, Heinz Dieter

(56) Entgegenhaltungen:
- EP-A- 0 313 249
- WO-A-00/25362
- DE-A1- 2 253 388
- DE-A1- 4 317 215
- DE-A1- 19 531 369
- DE-A1- 19 700 963
- JP-A- 8 125 071
- JP-A- 9 135 057
- US-A- 4 580 156
- US-A- 5 382 825
- SCHUTZE T ET AL: "Further improvements in the reliability of IGBT modules" CONFERENCE RECORD OF 1998 IEEE INDUSTRY APPLICATIONS CONFERENCE. THIRTY-THIRD IAS ANNUAL MEETING (CAT. NO.98CH36242) IEEE NEW YORK, NY, USA, Bd. 2, 1998, Seiten 1022-1025 vol., XP002338912 ISBN: 0-7803-4943-1
- "Characteristic properties of Silicone Rubber Compounds", , 10 April 2011 (2011-04-10), pages 1-16, XP55003777, Tokyo, Japan Retrieved from the Internet: URL:http://www.silicone.jp/e/catalog/pdf/r ubber_e.pdf [retrieved on 2011-07-28]

## Beschreibung

Die vorliegende Erfindung betrifft ein Substrat für Hochspannungsmodule nach dem Oberbegriff des Patentanspruches 1.

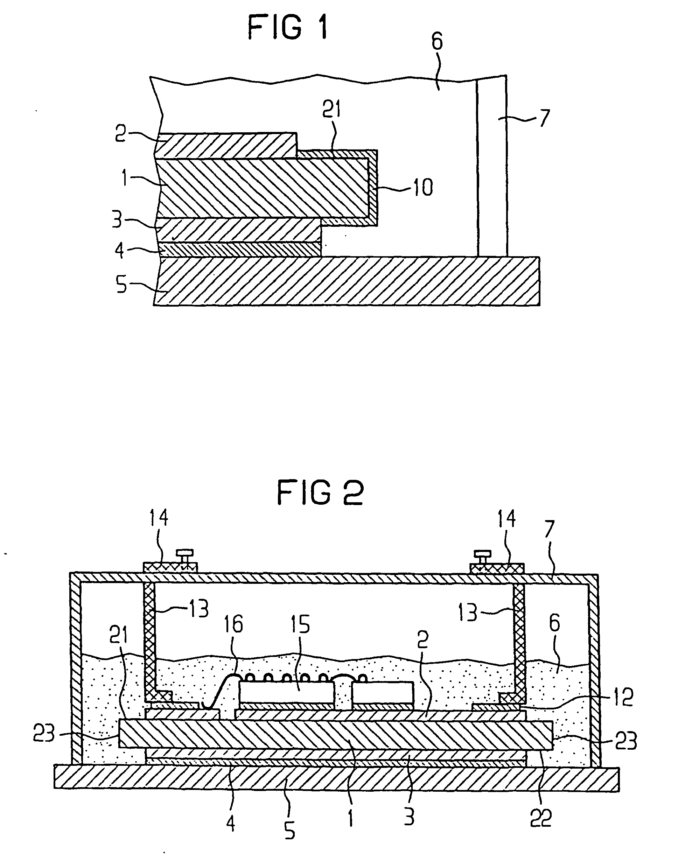

Leistungshalbleiterbauelemente, insbesondere IGBTs, sind auf einem Metall-Keramik-Substrat befestigt. Ein typischer Aufbau ist im Querschnitt in der beigefügten Figur 2 dargestellt. Das verwendete Substrat umfaßt eine Keramikschicht 1, die üblicherweise z. B. Al₂O₃ oder AlN ist. Auf beiden Hauptseiten 21, 22 dieser Keramikschicht befinden sich Metallschichten 2, 3, die z. B. durch eine Kupfermetallisierung gebildet sind. Bei der Montage wird die untere Metallschicht 3 mittels einer Lötverbindung 4 auf einer Bodenplatte 5, die auch Kupfer sein kann, befestigt. Auf der oberen Metallschicht 2 werden die Leistungshalbleiterbauelemente 15, z. B. ein IGBT oder eine Diode, mittels einer weiteren Lötverbindung 12 befestigt. Die oberen Anschlußkontakte der Leistungshalbleiterbauelemente 15 werden z. B. mittels eines Bonddrahtes 16 zu einem separaten Anteil der oberen Metallschicht 2 geführt. Auf der oberen Metallschicht 2 sind mittels weiterer Lötverbindungen 12 elektrische Zuleitungen 13 angebracht, die zu externen Kontakten 14 zum Abgriff der Betriebsspannung geführt sind. Die Anordnung befindet sich in einem vorzugsweise aus Kunststoff gefertigten Gehäuse 7, das mit einer Vergußmasse 6 aufgefüllt ist. Die Vergußmasse 6 dient der elektrischen Isolation zur Umgebung.

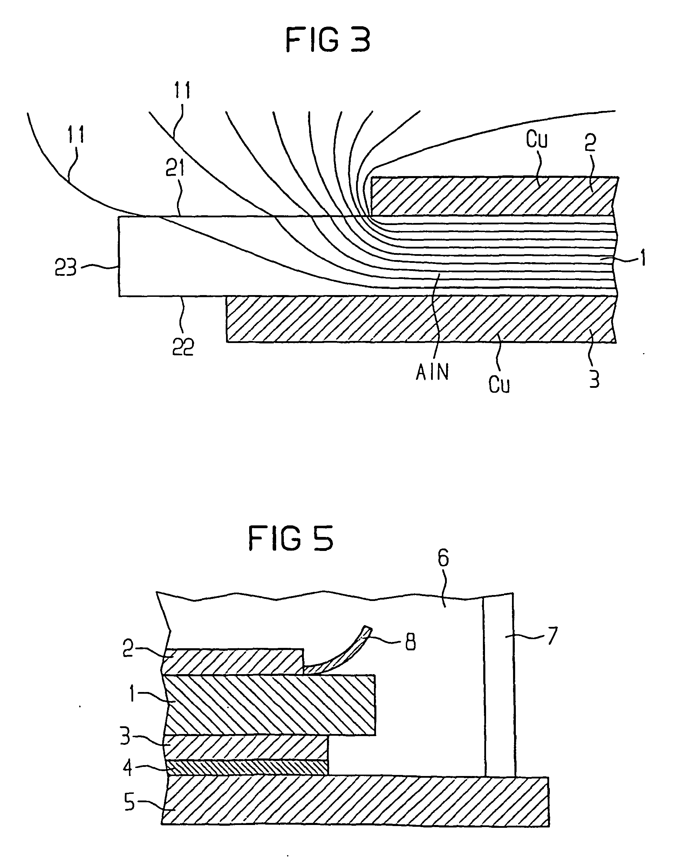

Die beigefügte Figur 3 zeigt den typischen Verlauf der Äquipotentialflächen anhand der durch Äquipotentiallinien 11 gegebenen Querschnitte im Bereich des Randes des Substrates. Die seitlichen Ränder der Metallschichten 2, 3 fallen nicht mit einer seitlichen Begrenzung 23 der Keramikschicht 1 zusammen. Der seitliche Rand der oberen Metallschicht 2 ist bei einer typischen Ausgestaltung weiter von der seitlichen Begrenzung 23 entfernt als der seitliche Rand der unteren Metallschicht 3. Das Substrat ist folglich einem Sockel ähnlich ausgebildet. Die Äquipotentiallinien 11 treten aus der mit der oberen Metallschicht 2 versehenen ersten Hauptseite 21 der Keramikschicht 1 aus, was in Figur 3 dargestellt ist. Die elektrische Feldstärke, der Gradient der Äquipotentialflächen, ist im Randbereich der Metallschichten 2, 3 besonders groß und kann extreme Spitzenwerte annehmen. Diese hohen auftretenden Feldstärken am Rand einer Metallschicht sind die Ursache für eine hohe Teilentladung des Moduls, die bei der Überschreitung eines Schwellenwertes der Betriebsspannung plötzlich einsetzt und experimentell nachgewiesen wurde. Durch eine derartige hohe Teilentladung wird der Modul, insbesondere die Vergußmasse 6, dauerhaft geschädigt. Die Hochspannungsfestigkeit des Moduls ist damit begrenzt.

Die derzeitige Weiterentwicklung der IGBT-Module ist auf hohe Betriebsspannungen gerichtet, wie sie von Thyristoren bekannt sind. Die Spannungen zwischen Masse und dem elektrisch aktiven Teil des Moduls nehmen Werte oberhalb von 10 kV an, so daß an die Isolierfestigkeit der Module und an ihre Beständigkeit hohe Anforderungen gestellt werden.

Im einzelnen sind in SCHÜTZE T ET AL: "Further improvements in the reliability of IGBT modules" CONFERENCE RECORD OF 1998 IEEE INDUSTRY APPLICATIONS CONFERENCE, THIRTY-THIRD IAS ANNUAL MEETING (CAT. NO. 98CH36242) IEEE NEW YORK, NY, USA, Bd. 2, 1998, Seiten 1022-1025, XP002338912 ISBN: 0-7803-4943-1, verschiedene Maßnahmen beschrieben, die zur Steigerung der Zuverlässigkeit von IGBT-Modulen ergriffen werden können. Zu diesen Maßnahmen gehören die Auswahl eines geeigneten Materials und einer geeigneten Schichtdicke für das Substrat.

Weiterhin ist aus der EP 0 313 249 A1 eine Halbleiterstruktur bekannt, bei der auf ein Halbleitersubstrat eine semiisolierende Siliziumnitridschicht als Feldabschirmung aufgetragen ist.

Aus dem Dokument JP-A-8 125 071 ist ein Substrat für Hochspannungsmodule bekannt, bei dem eine oberseitige Metallisierung mit einer unterseitigen Metallisierung durch eine Schicht aus Silikongummi bzw. Silikonkantschuk verbunden ist. Die Schicht weist verbesserte Haftungseigenschaften auf der Oberfläche der Keramikschicht im Vergleich zur Vergussmasse auf und erhöht dadurch die Spannungsfestigkeit des Moduls.

Es ist Aufgabe der vorliegenden Erfindung, ein Substrat für Hochspannungsmodule anzugeben, das auch für wesentlich höhere Betriebsspannungen als 3 kV geeignet ist.

Diese Aufgabe wird mit dem Substrat mit den Merkmalen des Anspruches 1 gelöst. Vorteilhafte Ausgestaltungen ergeben sich aus den abhängigen Ansprüchen.

Bei dem erfindungsgemäßen Substrat, das eine mit zwei Metallschichten versehene Keramikschicht umfaßt, sind anschließend an die Ränder der oberen Metallschicht an der Oberfläche der Keramikschicht Mittel vorhanden, die den Betrag der elektrischen Feldstärke an den Rändern der Metallschichten begrenzen. Das geschieht, um zu verhindern, daß an dieser Stelle hohe elektrische Feldstärken auftreten, die einen mit dem Substrat hergestellten Hochleistungsmodul schädigen können. Daher wird für eine gleichmäßige Verteilung des elektrischen Potentials an der Oberfläche der Keramikschicht gesorgt. Ein derartiger Potentialausgleich wird zum Beispiel durch eine ausreichend hochohmige und ausreichend dünne elektrisch leitende Schicht an der Oberseite der Keramikschicht herbeigeführt, mit der die Ränder der oberen Metallschicht hochohmig mit der unteren Metallschicht verbunden werden. Vorzugsweise ist diese Schicht ausreichend leitfähig, um auch bei schnellen Schaltvorgängen im hohen Spannungsbereich (z.B. typisch 6 kV/µs bis 10 kV/µs) einen ausreichenden Potentialausgleich herbeizuführen. Es ist auch möglich, an den Rändern der oberen Metallschicht jeweils seitlich einen mit zunehmender Entfernung von dem betreffenden Rand zunehmend nach oben gebogenen elektrischen Leiter anzubringen.

Es folgt eine genauere Beschreibung des erfindungsgemäßen Substrates anhand der in den beigefügten Figuren erläuterten Beispiele. Es zeigen:
- Figur 1: den Rand einer bevorzugten Ausführungsform ei- nes erfindungsgemäßen Metall-Keramik-Substra- tes,
- Figur 2: den eingangs erläuterten Aufbau eines Hochlei- stungsmoduls,
- Figur 3: den Verlauf der Äquipotentialflächen in einem Ausschnitt aus Figur 2.
- Figur 4: ein weiteres Ausführungsbeispiel eines erfin- dungsgemäßen Substrates im Querschnitt ein- schließlich des Verlaufes der Äquipotenti- alflächen, und
- Figur 5: ein für das Verständnis der Erfindung nützli- ches Substrat.

In Figur 1 ist ein Ausschnitt aus dem Aufbau eines Hochleistungsmoduls gemäß Figur 2 mit einem erfindungsgemäßen Substrat im Querschnitt dargestellt. Das Substrat ist ein Metall-Keramik-Substrat, bestehend aus einer Keramikschicht 1, die z. B. Al₂O₃ oder AlN ist, einer oberen Metallschicht 2, z. B. aus Kupfer, sowie einer unteren Metallschicht 3, z. B. ebenfalls aus Kupfer. Die Lötverbindung 4 und die Bodenplatte 5 eines Modul-Aufbaus sind hier ebenfalls eingezeichnet. Das Substrat, von dem hier nur der Rand gezeigt ist, wird zur Herstellung eines Moduls vorzugsweise in eine Vergußmasse 6 eingegossen und in einem Gehäuse 7 angeordnet.

Bei dem in Figur 1 dargestellten Ausführungsbeispiel befindet sich auf der ersten Hauptseite 21 der Keramikschicht 1 angrenzend an die obere Metallschicht 2 eine hochohmige Schicht 10 aus einem elektrisch leitfähigen Material. Diese Schicht 10 kann den gesamten nicht mit der oberen Metallschichten 2 bedeckten Anteil der Keramikschicht 1 bedecken. Die hochohmige Schicht 10 ist mit der unteren Metallschicht 3 elektrisch leitend verbunden und bedeckt bei diesem Ausführungsbeispiel die seitlichen Berandungen und die zweite Hauptseite der Keramikschicht bis angrenzend an die untere Metallschicht 3. Grundsätzlich genügt es aber, wenn nur auf der ersten Hauptseite 21 der Keramikschicht 1 anschließend an die Ränder der oberen Metallschicht 2 eine solche hochohmige Schicht 10 vorhanden ist, die mit der unteren Metallschicht 3 derart elektrisch leitend verbunden ist, daß eine Potentialdifferenz zwischen der oberen Metallschicht 2 und unteren Metallschicht 3 anliegen kann, die über die hochohmige Schicht 10 abfällt. Die Schicht 10 kann zum Beispiel an ihren äußeren Rändern mittels elektrischer Leiterbahnen mit der unteren Metallschicht 3 elektrisch leitend verbunden, d. h. kurzgeschlossen, sein.

Die hochohmige Schicht 10 grenzt vorzugsweise an alle Ränder der oberen Metallschicht 2 an, also nicht nur außen an den Rändern des Substrates, sondern auch zwischen den gegebenenfalls mehreren Anteilen der oberen Metallschicht, wie sie in Figur 2 als Beispiel eingezeichnet sind. Die hochohmige Schicht ist in einer bevorzugten Ausgestaltung so ausgebildet, daß bei Anliegen einer elektrischen Spannung im Bereich von 3 kV bis 10 kV zwischen der oberen Metallschicht 2 und der unteren Metallschicht 3 der Betrag der elektrischen Feldstärke an den seitlichen Rändern der Metallschicht höchstens 4 V/mm beträgt.

Die hochohmige Schicht 10 ist vorzugsweise ein schwach elektrisch leitendes Material. In der Erfindung wird sie durch eine dünne Metallschicht, deren spezifischer Widerstand durch Oxidationsprozesse eingestellt werden kann gebildet. Dafür ist insbesondere CrNi besonders geeignet. Erfindungsgemäß kann statt Metall elektrisch leitfähig dotiertes amorphes Silizium verwendet werden, dessen Leitfähigkeit durch die Dotierungskonzentration leicht in geeigneter Weise eingestellt werden kann (spezifischer Widerstand typisch 10⁵Ωcm). Das geschieht insbesondere im Hinblick darauf, daß eine ausreichende elektrische Isolation erforderlich ist, während gleichzeitig ein schneller Potentialausgleich für Schaltvorgänge gefordert ist, bei denen in kurzer Zeit hohe Spannungsanstiege auftreten. Möglich ist auch die Abscheidung von amorphem Kohlenstoff a-C:H, dessen Leitfähigkeit gezielt mittels Dotierung mit Bor, Stickstoff oder Zinn eingestellt werden kann. Statt eine gesonderte Schicht 10 aufzubringen, kann es gemäß der Erfindung genügen, einen Schichtanteil der Keramikschicht 1 zumindest an deren erster Hauptseite 21 z. B. mittels einer Ti-Implantation elektrisch leitfähig zu dotieren.

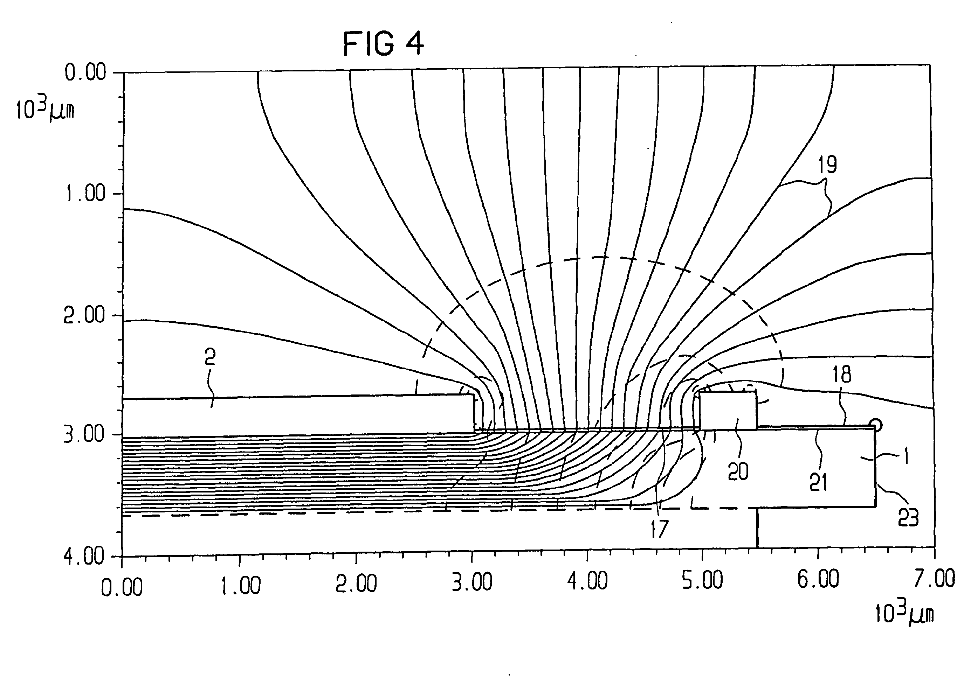

Figur 4 zeigt im Querschnitt ein weiteres Ausführungsbeispiel, von dem die Keramikschicht 1 und die obere Metallschicht 2 dargestellt sind. Hierbei ist eine Randmetallisierung 20 vorhanden, die rings um die obere Metallschicht 2 und im Abstand dazu auf der ersten Hauptseite 21 der Keramikschicht 1 angebracht ist. Die Randmetallisierung 20 ist mit der unteren Metallschicht 3 elektrisch leitend verbunden, so daß die Randmetallisierung 20 auf dem elektrischen Potential der unteren Metallschicht 3 liegt. Zwischen der oberen Metallschicht 2 und dieser Randmetallisierung 20 befindet sich auf der ersten Hauptseite 21 der Keramikschicht 1 die hochohmige Schicht als innere hochohmige Schicht 17. Falls die obere Metallschicht 2 in mehrere Anteile zerfällt, grenzt die innere hochohmige Schicht 17 vorzugsweise an alle Ränder dieser Anteile an. Die innere hochohmige Schicht 17 kann entsprechend einer hochohmigen Schicht bei den zuvor anhand der Figur 1 beschriebenen Ausführungsbeispielen ausgebildet sein. Eine äußere leitfähige Schicht 18 zwischen der Randmetallisierung 20 und der seitlichen Berandung 23 der Keramikschicht kann nach Art einer Feldplatte zusätzlich vorhanden sein. Der typische Verlauf der Äquipotentialflächen bei Anliegen einer Betriebsspannung zwischen der oberen Metallschicht 2 und der unteren Metallschicht 3 ist durch die eingezeichneten Äquipotentiallinien 19 dargestellt.

Bei dem Substrat gemäß Figur 5, das kein Ausführungsbeispiel der Erfindung ist, befindet sich auf der mit der oberen Metallschicht 2 versehenen ersten Hauptseite 21 der Keramikschicht 1 am Rand der oberen Metallschicht 2 ein elektrischer Leiter 8. Dieser elektrische Leiter 8 schließt an den Rand der oberen Metallschicht 2 elektrisch leitend an und weist mit zunehmendem Abstand von der oberen Metallschicht 2 einen zunehmenden Abstand von der Keramikschicht 1 auf. Er kann z. B. die in Figur 5 dargestellte nach oben gekrümmte Formgebung aufweisen. Dieser elektrische Leiter beeinflußt die Äquipotentialflächen am Rand der oberen Metallschicht 2, da das elektrische Feld im Inneren des elektrischen Leiters verschwindet.

## Patentansprüche

1. Substrat für Hochspannungsmodule mit
einer Keramikschicht (1) mit einer ersten Hauptseite (21) und einer der ersten gegenüberliegenden zweiten Hauptseite (22), einer oberen Metallschicht (2) auf der ersten Hauptseite und einer unteren Metallschicht (3) auf der zweiten Hauptseite, wobei:
- an der Oberfläche der Keramikschicht (1) an deren erster Hauptseite (21) eine hochohmige Schicht (10, 17) ausgebildet ist, die auf der ersten Hauptseite (21) der Keramikschicht (1) an die obere Metallschicht (2) angrenzt,
- die hochohmige Schicht (10, 17) an die untere Metallschicht (3) oder an einen mit der unteren Metallschicht (3) elektrisch leitend verbundenen elektrischen Leiter angrenzt und
- die hochohmige Schicht (10, 17) eine zum Anlegen einer Betriebsspannung von mehr als 3 kV zwischen der oberen Metallschicht (2) und der unteren Metallschicht (3) ausreichend geringe elektrische Leitfähigkeit aufweist,
**dadurch gekennzeichnet, dass**
die hochohmige Schicht (10, 17) Metall oder elektrisch leitend dotiertes amorphes Silizium oder elektrisch leitend dotierter armorpher Kohlenstoff oder eine in der Keramikschicht (1) ausgebildete elektrisch leitend dotierte Schicht ist.

2. Substrat nach Anspruch 1,
bei dem die hochohmige Schicht (10, 17) CrNi ist.

3. Substrat nach Anspruch 1 oder 2,
bei dem die hochohmige Schicht (10, 17) so ausgebildet ist, dass
bei Anliegen einer elektrischen Spannung im Bereich von 3 kV bis 10 kV zwischen der oberen Metallschicht (2) und der unteren Metallschicht (3) der Betrag der elektrischen Feldstärke an den seitlichen Rändern der oberen Metallschicht (2) höchstens das Doppelte des maximalen Wertes der im Inneren der Keramikschicht (1) auftretenden elektrischen Feldstärke ist.

4. Substrat nach Anspruch 1 oder 2,
bei dem die hochohmige Schicht (10, 17) so ausgebildet ist, dass bei Anliegen einer elektrischen Spannung im Bereich von 3 kV bis 10 kV zwischen der oberen Metallschicht (2) und der unteren Metallschicht (3) der Betrag der elektrischen Feldstärke an den seitlichen Rändern der oberen Metallschicht (2) höchstens 4V/mm beträgt.

## Claims

1. Substrate for high-voltage modules comprising a ceramic layer (1) having a first main side (21) and a second main side (22) opposite the first main side,
an upper metal layer (2) on the first main side, and
a lower metal layer (3) on the second main side, wherein:
- a high-resistance layer (10, 17) is formed at the surface of the ceramic layer (1) at the first main side (21) thereof, said high-resistance layer adjoining the upper metal layer (2) on the first main side (21) of the ceramic layer (1),
- the high-resistance layer (10, 17) adjoins the lower metal layer (3) or an electrical conductor electrically conductively connected to the lower metal layer (3), and
- the high-resistance layer (10, 17) has an electrical conductivity low enough for applying an operating voltage of more than 3 kV between the upper metal layer (2) and the lower metal layer (3),
**characterized in that**
the high-resistance layer (10, 17) is metal or electrically conductively doped amorphous silicon or electrically conductively doped amorphous carbon or an electrically conductively doped layer formed in the ceramic layer (1).

2. Substrate according to Claim 1,
wherein the high-resistance layer (10, 17) is CrNi.

3. Substrate according to Claim 1 or 2,
wherein the high-resistance layer (10, 17) is embodied such that when an electrical voltage in the range of 3 kV to 10 kV is present between the upper metal layer (2) and the lower metal layer (3), the absolute value of the electric field strength at the lateral edges of the upper metal layer (2) is at most twice the maximum value of the electric field strength occurring within the ceramic layer (1).

4. Substrate according to Claim 1 or 2,
wherein the high-resistance layer (10, 17) is embodied such that when an electrical voltage in the range of 3 kV to 10 kV is present between the upper metal layer (2) and the lower metal layer (3), the absolute value of the electric field strength at the lateral edges of the upper metal layer (2) is at most 4 V/mm.

## Revendications

1. Substrat pour des modules de haute tension comprenant
une couche (1) en céramique ayant une première face (21) principale et une deuxième face (22) principale opposée à la première,
une couche (2) métallique supérieure sur la première face principale et une couche (3) métallique inférieure sur la deuxième face principale,
dans lequel :
- il est formé, à la surface de la couche (1) en céramique, sur sa première face (21) principale, une couche (10, 17) très ohmique, qui, sur la première face (21) principale de la couche (1) en céramique, est voisine de la couche (2) métallique supérieure,
- la couche (10, 17) très ohmique est voisine de la couche (3) métallique inférieure ou d'un conducteur électrique relié d'une manière conductrice de l'électricité à la couche (3) métallique inférieure et
- la couche (10, 17) très ohmique a une conductivité électrique suffisamment petite pour l'application d'une tension de fonctionnement de plus de 3 kV entre la couche (2) métallique supérieure et la couche (3) métallique inférieure, **caractérisé en ce que**
la couche (10, 17) très ohmique est du métal ou du silicium amorphe dopé, conducteur de l'électricité ou du carbone amorphe dopé, conducteur de l'électricité ou une couche dopée, conductrice de l'électricité et formée dans la couche (1) en céramique.

2. Substrat suivant la revendication 1,
dans lequel la couche (10, 17) très ohmique est du CrNi.

3. Substrat suivant la revendication 1 ou 2,
dans lequel la couche (10, 17) très ohmique est constituée de manière à ce que,
lors de l'application d'une tension électrique dans la plage de 2 kV à 10 kV entre la couche (2) métallique supérieure et la couche (3) métallique inférieure, la valeur absolue des intensités de champ électrique sur les bords latéraux de la couche (2) métallique supérieure représente au plus deux fois la valeur maximum des intensités de champ électrique se produisant à l'intérieur de la couche (1) en céramique.

4. Substrat suivant la revendication 1 ou 2,
dans lequel la couche (10, 17) très ohmique est constituée de manière à ce que,
lors de l'application d'une tension électrique dans la plage de 3 kV à 10 kV entre la couche (2) métallique supérieure et la couche (3) métallique inférieure, la valeur absolue des intensités de champ électrique sur les bords latéraux de la couche (2) métallique supérieure est au plus de 4 V/mm.
